# EUROPEAN PATENT APPLICATION

(11) **EP 4 243 076 A1**
(43) Date of publication of application: **13.09.2023**
(21) Application number: 20966390.5
(22) Date of filing: 23.12.2020
(51) Int. Cl.: H01L 27/32, H01L 51/52

(54) **DISPLAY PANEL AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HUANG, Yao, Beijing 100176 (CN); DU, Lili, Beijing 100176 (CN); WU, Chao, Beijing 100176 (CN); LONG, Yue, Beijing 100176 (CN); LIU, Cong, Beijing 100176 (CN); ZHOU, Rui, Beijing 100176 (CN); HUANG, Weiyun, Beijing 100176 (CN); SHI, Bo, Beijing 100176 (CN); YU, Chi, Beijing 100176 (CN); WANG, Qiwei, Beijing 100176 (CN)
(74) Representative: Lavoix
(86) International application number: PCT/CN2020/138660
(87) International publication number: WO 2022/133813

(57) **Abstract**

A display panel and a display apparatus are provided in the present disclosure. The display panel has a display region comprising a first display region and a second display region, and a density of pixel circuits in the first display region is less than a density of pixel circuits in the second display region; the display panel includes: a base substrate; a plurality of first pixel circuits disposed on the base substrate and located in the second display region; a plurality of first traces disposed on a side of the first pixel circuits away from the base substrate; a pixel defining layer disposed on a side of the first traces away from the base substrate and defining a plurality of openings; a plurality of first light emitting devices disposed on the side of the first traces away from the base substrate and located in the first display region, where the first light emitting devices have effective light emitting regions respectively located in the openings, the first light emitting devices have first anodes each comprising an effective light emitting anode region and a non-light emitting anode region disposed surrounding the effective light emitting anode region, and the pixel defining layer covers the non-light emitting anode region; where the first traces are respectively electrically connected with the first pixel circuits through first vias and respectively electrically connected with the first anodes through second vias, and orthographic projections of the second vias on the base substrate are respectively located in orthographic projections of the first anodes on the base substrate.

## Description

### TECHNICAL FIELD

The present disclosure relates to the field of display technologies, and in particular to a display panel and a display apparatus.

### BACKGROUND

Organic light emitting diodes (OLEDs), with their low power consumption, high colour saturation, wide viewing angle, thinness and flexibility, are becoming the mainstream in the field of display technologies and can be widely used in end products such as smartphones, tablet PCs and TVs. However, transmittance of OLED display panels still needs to be further improved, especially in the application of under-screen cameras, where the cameras are disposed on back sides of the display regions of the screens and regions corresponding to the under-screen cameras can be used for display and also allows photography functions. The current OLED display panels are not conducive to good photography effect of the under-screen cameras due to poor transmittance, and the current under-screen cameras have a severe glare phenomenon when taking pictures.

Therefore, researches into OLED display panels are yet to be further developed.

### SUMMARY

The present disclosure is intended to solve, at least to some extent, one of the technical problems in the related art. To this end, an object of the present disclosure is to provide a display panel in which the transmittance is better.

In one aspect of the present disclosure, a display panel is provided in the present disclosure. According to the embodiments of the present disclosure, the display panel has a display region including a first display region and a second display region, and a density of pixel circuits in the first display region is less than a density of pixel circuits in the second display region; the display panel includes: a base substrate; a plurality of first pixel circuits disposed on the base substrate and located in the second display region; a plurality of first traces disposed on a side of the first pixel circuits away from the base substrate; a pixel defining layer disposed on a side of the first traces away from the base substrate and defining a plurality of openings; a plurality of first light emitting devices disposed on the side of the first traces away from the base substrate and located in the first display region, where the first light emitting devices have effective light emitting regions respectively located in the openings, the first light emitting devices have first anodes each including an effective light emitting anode region and a non-light emitting anode region disposed surrounding the effective light emitting anode region, and the pixel defining layer covers the non-light emitting anode region; where the first traces are respectively electrically connected with the first pixel circuits through first vias and respectively electrically connected with the first anodes through second vias, and orthographic projections of the second vias on the base substrate are respectively located in orthographic projections of the first anodes on the base substrate. As a result, the first trace is directly electrically connected with the first anode through the second via, without the need to dispose a protruding portion around the first anode for electrically connecting with the first trace, so that the transmittance of the first display region may be further improved. Furthermore, without disposing the protruding portion, it can reduce the diffraction effect of the light hitting onto the first anode and when the under-screen camera is disposed on the back of the display panel corresponding to the first display region, it can effectively improve the glare phenomenon during photography of the display panel.

According to the embodiments of the present disclosure, the openings are shaped as circles, parts of circles, ovals or parts of ovals, and/or the first anodes are shaped as circles or ovals.

According to the embodiments of the present disclosure, the first light emitting devices include blue light emitting devices, red light emitting devices and green light emitting devices, first anodes in the blue light emitting devices are shaped as circles or sub-circular ovals, and first anodes in the red light emitting devices and the green light emitting devices are shaped as ovals.

According to the embodiments of the present disclosure, the display panel further includes: a first insulating layer disposed on the side of the first pixel circuits away from the base substrate, where the plurality of first traces are disposed on a surface of the first insulating layer away from the base substrate and respectively electrically connected with the first pixel circuits through the first vias penetrating the first insulating layer; a second insulating layer disposed on the surface of the first insulating layer away from the base substrate and covering the first traces, where the pixel defining layer is disposed on a side of the second insulating layer away from the base substrate, and the first anodes are respectively electrically connected with the first traces through the second vias penetrating the second insulating layer.

According to the embodiments of the present disclosure, portions of the orthographic projections of the second vias on the base substrate are respectively covered by orthographic projections of effective light emitting anode regions on the base substrate, and other portions thereof are respectively covered by orthographic projections of non-light emitting anode regions on the base substrate.

According to the embodiments of the present disclosure, the orthographic projections of the second vias on the base substrate are respectively covered by orthographic projections of the non-light emitting anode regions on the base substrate.

According to the embodiments of the present disclosure, the orthographic projections of the second vias on the base substrate are respectively covered by orthographic projections of effective light emitting anode regions on the base substrate.

According to the embodiments of the present disclosure, a material forming the first traces includes at least one of ITO and AZO.

According to the embodiments of the present disclosure, the display panel further includes: a plurality of second pixel circuits and a plurality of second light emitting devices that are both located in the second display region, where the second pixel circuits are respectively connected with second anodes in the second light emitting devices by at least one of following means: the second pixel circuits are directly electrically connected with the second anodes in the second light emitting devices through third vias, to drive the second light emitting devices to emit light; the display panel further includes a conductive layer disposed in a same layer as the first traces, the second anodes are electrically connected with the conductive layer through fourth vias penetrating the second insulating layer, and the conductive layer is electrically connected with the second pixel circuits through fifth vias penetrating the first insulating layer, to drive the second light emitting devices to emit light.

In another aspect of the present disclosure, a display apparatus is provided in the present disclosure. According to the embodiments of the present disclosure, the display apparatus further includes: the display panel described above; an under-screen functional layer, where an orthographic projection of the under-screen functional layer on the display panel overlaps the first display region of the display panel. As a result, the under-screen functional layer in this display apparatus has a large amount of incident light and when it is an under-screen camera, it can effectively improve its shooting quality and improve the glare phenomenon when it takes pictures. A person skilled in the art may understand that the display apparatus has all features and advantages of the display panel described above, and this will not be further elaborated herein.

### BRIEF DESCRIPTION OF DRAWINGS

FIG. 1 is a schematic diagram of a structure of a display panel in an embodiment of the present disclosure;
FIG. 2 is a schematic diagram of a structure of another display panel in an embodiment of the present disclosure;
FIG. 3 is a schematic plan view of yet another display panel in an embodiment of the present disclosure;
FIG. 4 is a sectional view taken along the line AA' in FIG. 3;
FIG. 5 is a schematic diagram of a structure of a first anode in the related arts;
FIG. 6 is a schematic diagram of a structure of yet another display panel in an embodiment of the present disclosure;
FIG. 7 is a schematic diagram of a structure of yet another display panel in an embodiment of the present disclosure;
FIG. 8 is a schematic diagram of structures of an opening in a pixel defining layer and a first anode in an embodiment of the present disclosure;
FIG. 9 is a schematic diagram of structures of an opening in another pixel defining layer and another first anode in an embodiment of the present disclosure;
FIG. 10 is a schematic diagram of structures of an opening in another pixel defining layer and another first anode in an embodiment of the present disclosure;
FIG. 11 is a schematic diagram of structures of an opening in another pixel defining layer and another first anode in an embodiment of the present disclosure;
FIG. 12 is a schematic diagram of structures of an opening in yet another pixel defining layer and yet another first anode in an embodiment of the present disclosure;
FIG. 13 is a schematic diagram of a structure of yet another display panel in an embodiment of the present disclosure;
FIG. 14 is a schematic diagram of a structure of yet another display panel in an embodiment of the present disclosure;
FIG. 15 is a schematic diagram of a structure of a display apparatus in an embodiment of the present disclosure;
FIG. 16 is a photograph taken by an under-screen camera;
FIG. 17 is a photograph taken by an under-screen camera;
FIG. 18 is a photograph taken by an under-screen camera.

### DETAILED DESCRIPTION

The following describes in detail embodiments of the present disclosure. The embodiments described below are exemplary and are intended to explain the present disclosure rather than limit the scope of the present disclosure. If no specific technology or condition is specified in the embodiments, the technologies or conditions described in the literature within the field or the product manual shall be adopted.

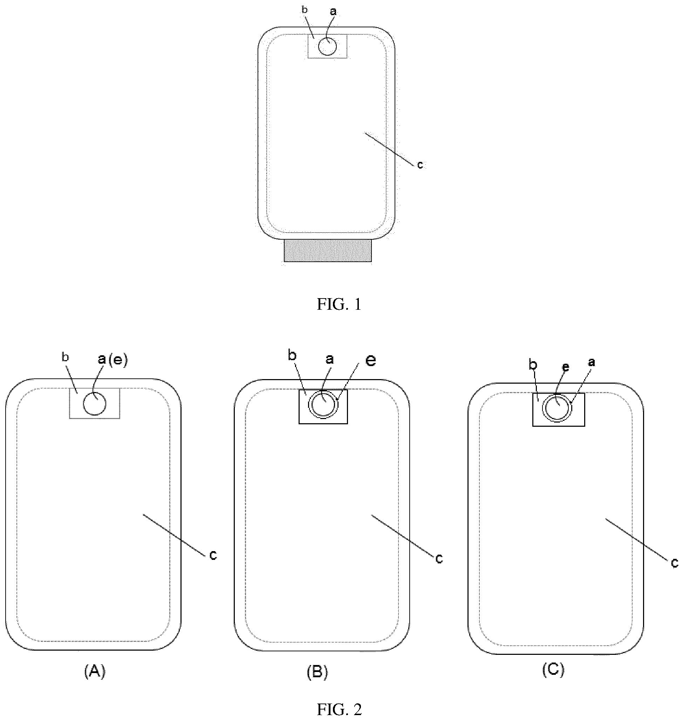

In one aspect of the present disclosure, a display panel is provided in the present disclosure. According to some embodiments of the present disclosure, the display panel has a display region including a first display region a and a second display region b. In some embodiments, the second display region b is located at an outer edge of the first display region a, which means that the second display region b is disposed at an outer side of the first display region a, or the second display region b is disposed surrounding a periphery of the first display region a. In addition, there is no special requirement for the specific setting position of the first display region a, and a person skilled in the art may flexibly choose it according to the actual design requirements of the under-screen functional region. For example, the first display region may be located in a center of the display panel, or in a corner of the display panel, or as shown in FIG. 1, the first display region may be located near a border of the display panel and centered.

Moreover, there is no specific requirement for a specific shape of the first display region a, and a person skilled in the art may flexibly choose it according to the actual situation. For example, the shape of the first display region a includes but is not limited to a circle, an ellipse, a polygon such as a quadrilateral, a pentagon, or a hexagon, or an irregular shape.

Density of pixel circuits in the first display region a is less than density of pixel circuits in the second display region b, which means that distribution density of the pixel circuits in the first display region a (i.e., the first pixel circuits referred to in the following text) is less than distribution density of the pixel circuits in the second display region b. It will be noted that the pixel circuits in the text refer to the driving circuits that provide drive voltage for OLED light emitting devices, and may be of circuit structures such as 7T1C or 9T2C. It will be noted that the pixel circuit is used to drive the light emitting device (OLED device) to emit light, and includes structures such as an active layer, a gate, source-drain, a storage capacitor, a data line, and a scan line.

In addition, as shown in FIG. 1, the display region of the display panel further includes a third display region c, which is located on a side of the second display region b away from the first display region a. The density of the pixel circuits in the third display region is greater than the density of the pixel circuits in the second display region. In some embodiments, a small number of pixel circuits may be provided in the first display region a, although it is needed to ensure that sufficient light can pass through the region. In some other embodiments, the density of the pixel circuits in the first display region may be 0, i.e., pixel circuits may not be disposed in the first display region, and first light emitting devices located in the first display region are all driven by the first pixel circuits in the second display region.

In addition, the distribution density of the light emitting devices in the first display region a may be less than or equal to the distribution density of the light emitting devices in the second display region b, and the distribution density of the light emitting devices in the second display region b may be less than or equal to the distribution density of the light emitting devices in the third display region c. Based on the above structure, the distribution density of the pixel circuits in the first display region a is the smallest, and it is ensured that sufficient light passes through the first display region and reach a back of the display panel. Meanwhile, by providing drive voltage for the light emitting devices in the first display region a through the first pixel circuits in the second display region b, the display resolution (PPI) of the first display region a can be equal to or slightly lower than the display resolution of other regions.

According to the embodiments of the present disclosure, as shown in FIG. 2, the display region further includes an under-screen functional region e, which overlaps with the first display region a. In some specific embodiments, as shown in (A) of FIG. 2, the first display region a coincides with the under-screen functional region e; in some other embodiments, as shown in (B) of FIG. 2, the first display region a is covered by the under-screen functional region e; in yet other embodiments, as shown in (C) of FIG. 2, the under-screen functional region e is covered by the first display region a. The under-screen functional region refers to a region where the under-screen functional layer is disposed, and a part of the back of the display panel corresponding to the under-screen functional region is used to dispose the under-screen functional layer (e.g., an under-screen camera). The first display region has a high transmittance, which may meet the requirement of the amount of incident light for the under-screen camera, while greatly improving the screen-to-body ratio of the display panel.

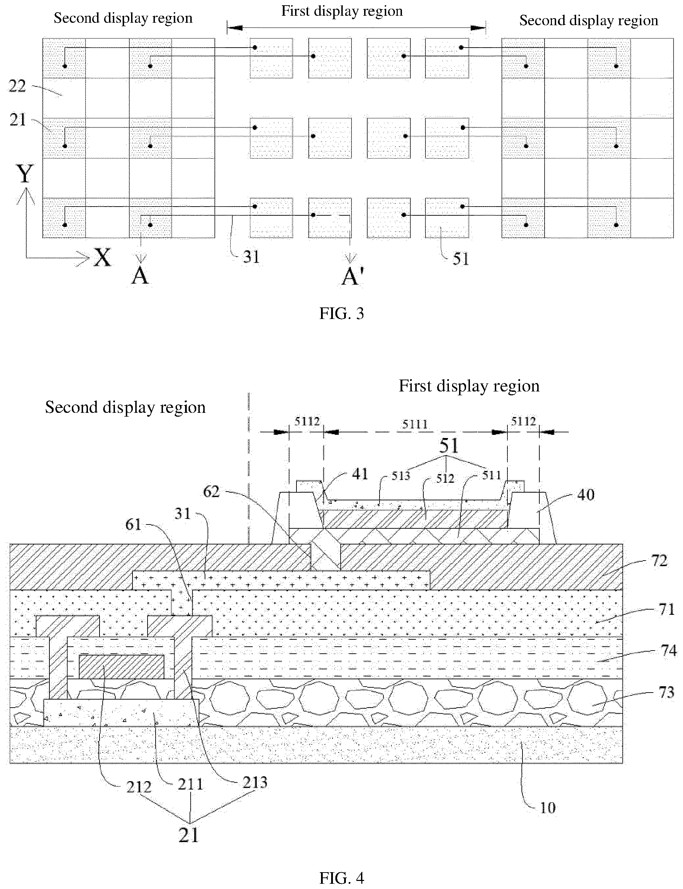

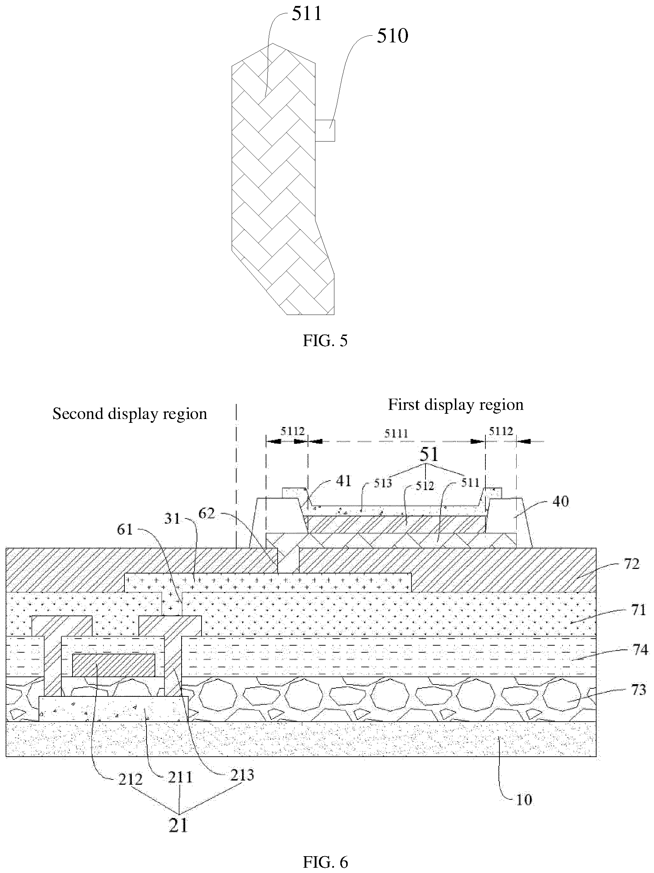

According to the embodiments of the present disclosure, referring to FIGS. 3 and 4, the display panel includes: a base substrate 10; a plurality of first pixel circuits 21(the drawings showing only one thin film transistor connected with the light emitting device in the pixel circuit as an example) disposed on the base substrate 10 and located in the second display region b; a plurality of first traces 30 disposed on a side of the first pixel circuits 21 away from the base substrate 10; a pixel defining layer 40 disposed on a side of the first traces away from the base substrate 10 and defining a plurality of openings 41; a plurality of first light emitting devices 51 disposed on a side of the first traces 30 away from the base substrate 10 and located in the first display region a, where the first light emitting device 51 has an effective light emitting region located in the opening 41, the first light emitting device 51 has a first anode 511 including an effective light emitting anode region 5111 and a non-light emitting anode region 5112 disposed surrounding the effective light emitting anode region 5111, and the pixel defining layer 40 covers the non-light emitting anode region 5112. The first trace 31 is electrically connected with the first pixel circuit 21 through a first via 61 and electrically connected with the first anode 511 through a second via 62. An orthographic projection of the second via 62 on the base substrate 10 is located inside an orthographic projection of the first anode 511 on the base substrate 10. As a result, the first trace 31 is directly electrically connected with the first anode 511 through the second via 62, without the need to dispose a protruding portion 510 around the first anode 511 (as shown in FIG. 5, the protruding portion 510 having a same structure as the first anode for electrically connecting with the first trace) for electrically connecting with the first trace, so that the transmittance of the first display region may be further improved. Furthermore, without disposing the protruding portion, it can reduce the diffraction effect of the light hitting onto the first anode and when the under-screen camera is disposed on the back of the display panel corresponding to the first display region, it can effectively improve the glare phenomenon during photography of the display panel.

The effective light emitting anode region mentioned above refers to a region of the first anode located inside an opening defined by the pixel defining layer, i.e., the effective light emitting region corresponding to the first light emitting device.

According to the embodiments of the present disclosure, with reference to FIG. 4, which shows a sectional view taken along the line AA' in FIG. 3, the display panel further includes: a first insulating layer 71 disposed on a side of the first pixel circuit 21 away from the base substrate 10; a plurality of first traces 31 disposed on a surface of the first insulating layer 71 away from the base substrate 10 and electrically connected with the first pixel circuit 21 through a first via 61 penetrating the first insulating layer 71; a second insulating layer 72 disposed on a surface of the first insulating layer 71 away from the base substrate 10 and covering the first traces 31, the pixel defining layer 40 being disposed on a side of the second insulating layer 72 away from the base substrate 10, where the first anode 511 is electrically connected with the first trace 31 through the second via 62 penetrating the second insulating layer 72.

There are no special requirement for the specific structure of the first pixel circuit 21, and a person skilled in the art may flexibly choose it according to actual conditions. In some embodiments, the first pixel circuit 21 is a structure of 7T1C circuit (i.e., seven transistors and one capacitor), including a driving transistor, a data writing transistor, a storage capacitor, a threshold compensation transistor, a first reset transistor, a second reset transistor, a first light emitting control transistor, and a second light emitting control transistor. There are no special requirements for the vertical structure of the first pixel circuit 21. In some embodiments, as shown in FIG. 4, the first pixel circuit 21 includes structures such as an active layer 211, a gate 212, and a source-drain layer 213. The active layer 211 is disposed on a side of the base substrate 10, and a gate insulating layer 73 covers the active layer 211. The gate 212 is disposed on a surface of the gate insulating layer 73 away from the base substrate 10, and an interlayer dielectric layer 74 is disposed on a side of the gate insulating layer 61 away from the base substrate 10, covering the gate 212. The source-drain layer 213 is disposed on a side of the interlayer dielectric layer 74 away from the base substrate 10, and the source-drain layer 213 is electrically connected with the active layer through a via penetrating the gate insulating layer and the interlayer dielectric layer. As shown in FIG. 4, the electrical connection between the first trace 31 and the first pixel circuit 21 is achieved by electrically connecting the first trace 31 with the source-drain layer 213.

In addition, referring to FIG. 4, the first light emitting device 51 includes a light emitting layer 512 and a cathode 513 in addition to the first anode 511 as previously described. In some embodiments, the first light emitting device 51 may further include at least one of structures such as a hole transport layer, a hole injection layer, an electron transport layer and an electron injection layer, and a person skilled in the art may flexibly choose it according to actual design requirements.

According to the embodiments of the present disclosure, a material forming the first traces includes at least one of ITO and AZO. As a result, the first trace has a high transmittance, which further enables the first display region to have a high transmittance.

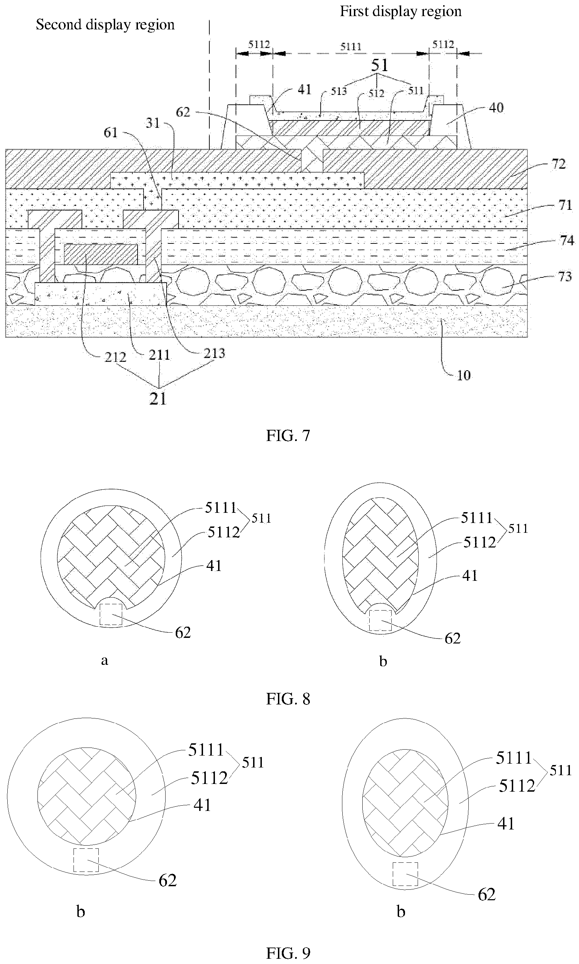

According to the embodiments of the present disclosure, the relative position between the second via 62 and the first anode 511 may include the followings:
In some embodiments, with reference to FIG. 4, a portion of an orthographic projection of the second via 62 on the base substrate 10 is covered by an orthographic projection of the effective light emitting anode region 5111 on the base substrate 10 and the other portion thereof is covered by an orthographic projection of the non-light emitting anode region 5112 on the base substrate 10. In some other embodiments, with reference to FIG. 6, the orthographic projection of the second via 62 on the base substrate 10 is covered by the orthographic projection of the non-light emitting anode region 5112 on the base substrate 10. In yet other embodiments, with reference to FIG. 7, the orthographic projection of the second via 62 on the base substrate 10 is covered by the orthographic projection of the effective light emitting anode region 5111 on the base substrate 10. As a result, the display panel of the above structure may effectively increase the transmittance in the first display region and also reduce the diffraction of light hitting onto the first anode, thus improving the glare phenomenon when the under-screen camera takes pictures.

According to the embodiments of the present disclosure, the opening 41 of the pixel defining layer is shaped as a circle, a part of a circle, an oval or a part of an oval, and/or the first anode is shaped as a circle or an oval. As a result, the above-mentioned shape of the opening and the first anode facilitate a greater use of the opening in the fine metal mask (FMM) plate, to evaporate more light emitting material (EL material) and increase the lifetime of the first light emitting device. In some embodiments, the first anode is shaped as a circle, the opening is also shaped as a circle; in some embodiments, the first anode is shaped as an oval, the opening is shaped as an oval or a circle. The specific shape of the first anode 511 and the opening 41 and the position of the second via 62 in relation to the first anode 511 and the opening 41 may be shown as follows:
In some embodiments, with reference to FIG. 8, the orthographic projection of the second via 62 on the base substrate 10 is covered by the orthographic projection of the non-light emitting anode region 5112 on the base substrate 10, where the first anode 511 is shaped as a circle or an oval and the opening 41 defined by the pixel defining layer (or the effective light emitting anode region 5111) is shaped as a part of a circle or a part of an oval. As a result, the non-light emitting anode region 5112 has a smaller width, i.e., the spacing between the edge of the first anode 511 and the opening 41 is smaller, thereby allowing as much EL material to be evaporated as possible and increasing the lifetime of the first light emitting device. It will be noted that a part of a circle means that the circle has a notch that causes the circle to be incomplete, and similarly, a part of an oval means that the oval has a notch that causes the circle to be incomplete.

In some other embodiments, referring to FIG. 9, the orthographic projection of the second via 62 on the base substrate 10 is covered by the orthographic projection of the non-light emitting anode region 5112 on the base substrate 10, where the first anode 511 is shaped as a circle or an oval and the opening 41 defined by the pixel defining layer (or the effective light emitting anode region 5111) is shaped as a circle or an oval. The structure in FIG. 9 compared to the structure in FIG. 8, the shape and size of the first anode 511 remains unchanged, the difference being that the shape of the opening 41 becomes smaller in size such that the orthographic projection of the second via 62 on the base substrate 10 is covered by the orthographic projection of the non-light emitting anode region 5112 on the base substrate 10. As a result, the effective light emitting anode region 5111 may be of a structure shaped as a complete circle or oval and maintain the spacing as small as possible between the edge of the first anode 511 and the opening 41.

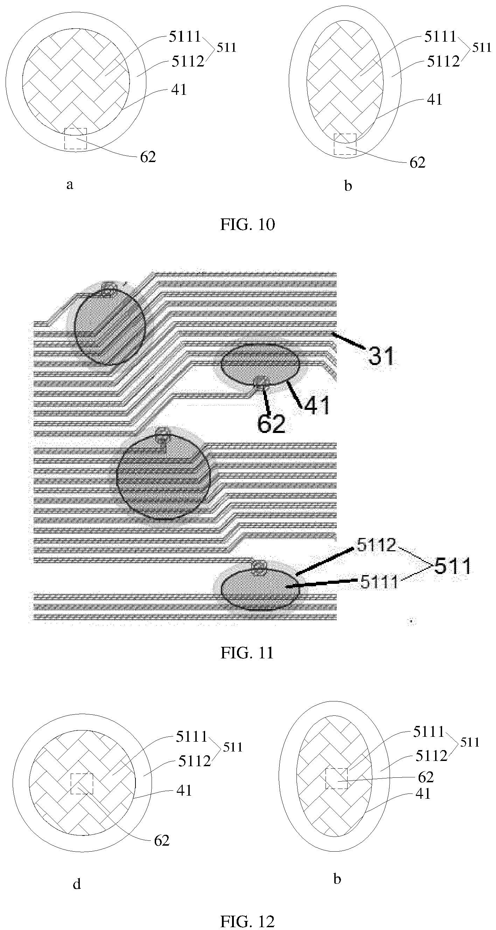

In yet other embodiments, with reference to FIGS. 10 and 11, a portion of an orthographic projection of the second via 62 on the base substrate 10 is covered by an orthographic projection of the effective light emitting anode region 5111 on the base substrate 10 and the other portion thereof is covered by an orthographic projection of the non-light emitting anode region 5112 on the base substrate 10. The first anode 511 is shaped as a circle or an oval and the opening 41 defined by the pixel defining layer (or the effective light emitting anode region 5111) is shaped as a circle or an oval. As a result, the non-light emitting anode region 5112 has a smaller width, i.e., the spacing between the edge of the first anode 511 and the opening 41 is smaller, thereby allowing as much EL material to be evaporated as possible and increasing the lifetime of the first light emitting device.

In yet other embodiments, with reference to FIG. 12, the orthographic projection of the second via 62 on the base substrate 10 is covered by the orthographic projection of the effective light emitting anode region 5111 on the base substrate 10, where the first anode 511 is shaped as a circle or an oval and the opening 41 defined by the pixel defining layer (or the effective light emitting anode region 5111) is shaped as a circle or an oval. As a result, the non-light emitting anode region 5112 has a smaller width, i.e., the spacing between the edge of the first anode 511 and the opening 41 is smaller, thereby allowing as much EL material to be evaporated as possible and increasing the lifetime of the first light emitting device.

However, in a same product (i.e., in a same display panel), a person skilled in the art may flexibly combine the specific settings of the second via, the first anode and the opening of the pixel defining layer in FIGS. 8 to 12 according to actual needs, to obtain a display panel with better performance.

According to the embodiments of the present disclosure, the first light emitting devices include a blue light emitting device, a red light emitting device and a green light emitting device, where a first anode in the blue light emitting device is shaped as a circle or a sub-circular oval, and first anodes in the red light emitting device and the green light emitting device are shaped as ovals. As a result, the light emitting efficiency of the first light emitting device may be increased as much as possible. It will be noted that the sub-circular oval means that long and short axes of the oval are relatively similar, and a specific size of a difference between the short and long axes is designed flexibly by a person skilled in the art according to actual situations and is not limited herein.

According to the embodiments of the present disclosure, compared to the technical solution in which a protruding portion is disposed around the first anode, a proportion of a hollow area of the first display region in the display panel of the present disclosure is increased from 91.419% to 92.208%, effectively increasing the transmittance of the first display region. A region of the first display region excluding the first anode region is defined as a hollow region, and an area of the hollow region is the hollow area.

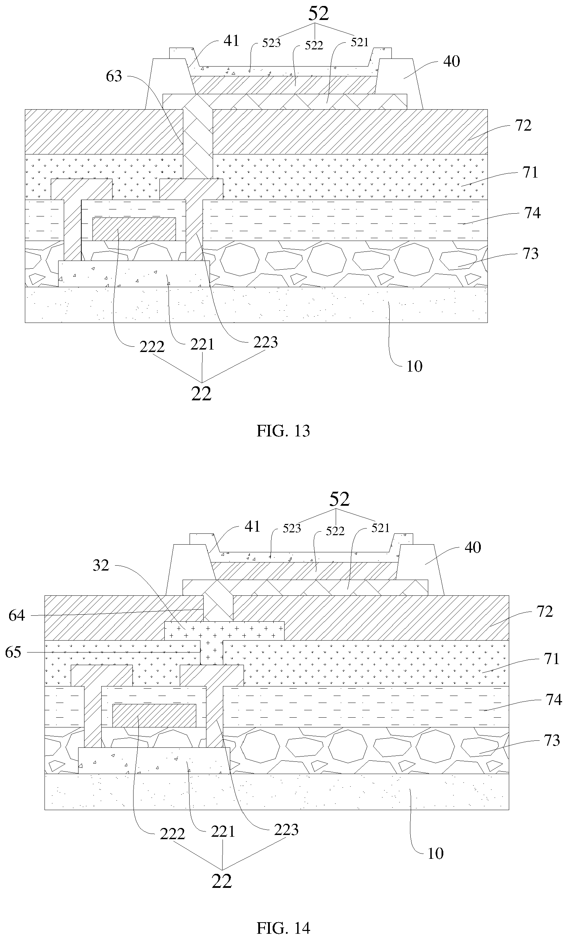

According to the embodiments of the present disclosure, with reference to FIGS. 3, 13, and 14, the display panel further includes a plurality of second pixel circuits 22 and a plurality of second light emitting devices 52, and the second pixel circuits 22 and the second light emitting devices 52 are both located in the second display region b. The second pixel circuits are respectively connected with second anodes in the second light emitting devices by at least one of following means:
In some embodiments, referring to FIG. 13, the second pixel circuit 22 is directly electrically connected with the second anode 521 in the second light emitting device 52 through a third via 63, to drive the second light emitting device 52 to emit light, where the third via 63 penetrates the first insulating layer 71 and the second insulating layer 72, and the second anode 521 is electrically connected with the source-drain layer 223 in the second pixel circuit through the third via 63.

In some other embodiments, referring to FIG. 14, the display panel further includes a conductive layer 32, which is disposed in a same layer as the first trace 31, the second anode 521 is electrically connected with the conductive layer 32 through a fourth via 64 penetrating the second insulating layer 72, and the conductive layer 32 is electrically connected with the second pixel circuit 22 through a fifth via 65 penetrating the first insulating layer 71 (i.e., the conductive layer 32 being electrically connected with the source-drain layer 223 in the second pixel circuit), to drive the second light emitting device 52 to emit light. As a result, electrically connecting the second pixel circuit with the second anode through the conductive layer 32 may help to reduce an impedance between the second anode and the source-drain layer.

Referring to FIGS. 13 and 14, the second light emitting device 52 includes a light emitting layer 522 and a cathode 523 in addition to the second anode 521 as previously described. In some embodiments, the second light emitting device 52 may further include at least one of structures such as a hole transport layer, a hole injection layer, an electron transport layer and an electron injection layer, and a person skilled in the art may flexibly choose it according to actual design requirements.

As shown in FIGS. 13 and 14, the second pixel circuit 22 includes structures such as an active layer 221, a gate 222, and a source-drain layer 223. The active layer 221 is disposed on a side of the base substrate 10, and a gate insulating layer 73 covers the active layer 221. The gate 222 is disposed on a surface of the gate insulating layer 73 away from the base substrate, and an interlayer dielectric layer 74 is disposed on a side of the gate insulating layer 73 away from the base substrate 10, covering the gate 222. The source-drain layer 223 is disposed on a side of the interlayer dielectric layer 74 away from the base substrate, and the source-drain layer 223 is electrically connected with the active layer through a via penetrating the gate insulating layer and the interlayer dielectric layer. As shown in FIGS. 12 and 13, the source-drain layer 223 in the second pixel circuit is electrically connected with the second anode 521.

In some embodiments, as shown in FIG. 3, the first pixel circuits 21 and the second pixel circuits 22 are arranged in an array in a first direction X and a second direction Y. To ensure uniform brightness in the second display region, a plurality of first pixel circuits 21 and second pixel circuits 22 may be evenly dispersed. The specific arrangement of the pixel units may be flexibly adopted by a person skilled in the art based on the specific situation, and is not limited to any specific requirement.

According to the embodiments of the present disclosure, there are no special requirements for the shape of the second anode. A person skilled in the art may flexibly choose it according to actual requirements. In some embodiments, the shape of the second anode may be designed as a conventional shape in the conventional art; in some other embodiments, the shape of the second anode may be designed as a circle or an oval identical to the shape of the first anode.

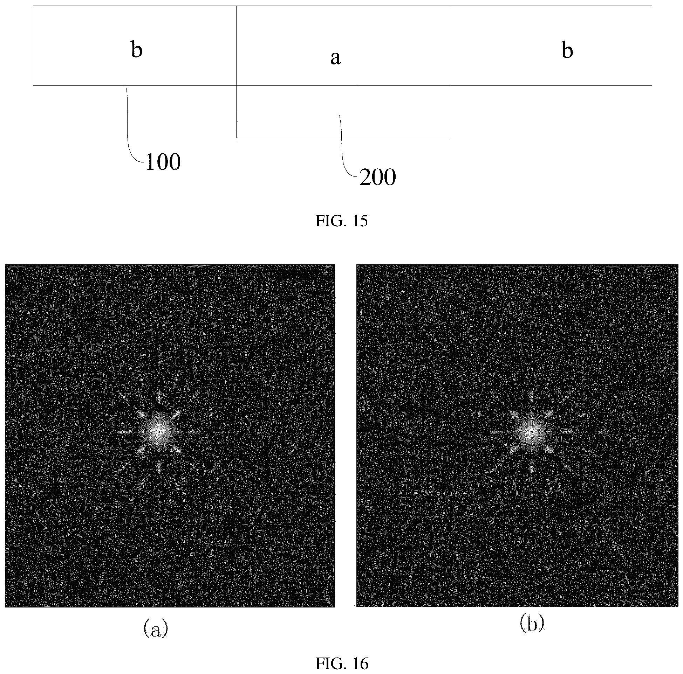

In another aspect of the present disclosure, a display apparatus is provided in the present disclosure. According to the embodiments of the present disclosure, referring to FIG. 15, the display apparatus includes: the display panel 100 as described above; an under-screen functional layer 200, where there is an overlapping region between an orthographic projection of the under-screen functional layer 200 on the display panel 100 and the first display region a of the display panel 100, or in other words, the orthographic projection of the under-screen functional layer 200 on the display panel 100 overlaps the under-screen functional region of the display panel 100. As a result, the under-screen functional layer in this display apparatus has a large amount of incident light and when it is an under-screen camera, it can effectively improve its shooting quality and improve the glare phenomenon when it takes pictures. A person skilled in the art may understand that the display apparatus has all features and advantages of the display panel described above, and this will not be further elaborated herein.

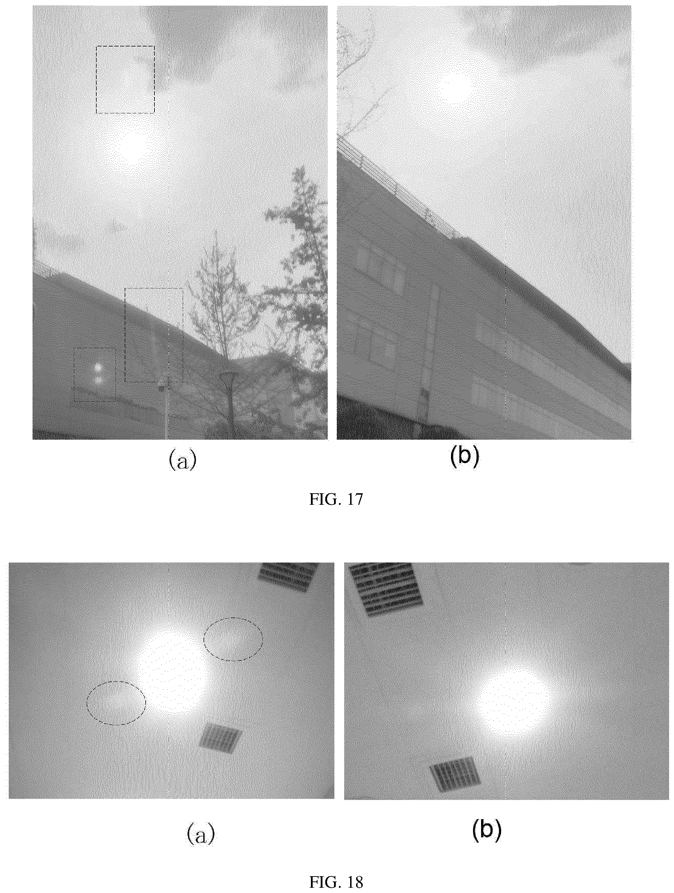

According to the embodiments of the present disclosure, as previously mentioned, since the first anode in the present disclosure does not need to be provided with a protruding portion electrically connected with the first trace, and thus can effectively improve the glare phenomenon when the under-screen camera takes pictures. Specifically, with reference to FIG. 16, 17 and 18, (a) of FIG. 16 shows a photograph taken by an under-screen camera in a display device with a protruding portion in a first anode. There are more white dots in the photograph, i.e., undesirable images due to the glare phenomenon. In the dashed boxes in (a) of FIG. 17 and (a) of FIG. 18, undesirable images due to the glare phenomenon are also evident in a photograph taken by the under-screen camera in the display device; while (b) of FIG. 16 shows a photograph taken by the under-screen camera in the display apparatus of the present disclosure under same conditions as the display device. The comparison shows that there are almost no white dots in (b) of FIG. 16 and there are no undesirable images due to the glare phenomenon in (b) of FIG. 17 and (b) of FIG. 18 compared to (a) of FIG. 17 and (a) of FIG. 18. It can be seen that, the undesirable phenomenon of glare can be greatly improved when the under-screen camera in the display apparatus of the present disclosure takes pictures.

According to the embodiments of the present disclosure, there are no special requirements for specific types of the structure of the under-screen functional layer. A person skilled in the art can flexibly choose it according to actual situations. In some specific embodiments, the under-screen functional layer may be an under-screen camera. As a result, it is possible to increase a screen-to-body ratio of the display panel while meeting requirements for the amount of incident light in the under-screen camera.

According to the embodiments of the present disclosure, there are no special requirements for specific types of the above display apparatus. A person skilled in the art may flexibly choose it according to actual conditions, for example, it can be a display device with display function such as a mobile phone, a notebook or a computer. Moreover, a person skilled in the art can understand that the above-mentioned display apparatus also has, in addition to the display panel and the under-screen functional layer described above, structures and components needed by a conventional display device. A mobile phone, for example, can also include essential structures and components such as a cover, a motherboard, a back cover and a middle frame.

It is understood by a person skilled in the art that the display apparatus may include, in addition to the display panel and the under-screen functional layer described above, structures or components needed by a conventional display device. A mobile phone also includes, for example, in addition to the display panel and the under-screen functional layer described above, structures or components such as a touch module, a glass cover, a housing, a voice module and a CPU.

In the descriptions of the present specification, terms such as "an embodiment", "some embodiments", "an example", "a specific example" or "some examples" are intended to refer to that a specific feature, structure, material, or characteristic described in combination with an embodiment or an example are included in at least one embodiment or example of the present disclosure. In the present specification, the illustrative expressions of the above terms do not necessarily refer to a same embodiment or example. Furthermore, specific feature, structure, material or characteristic described above may be combined in a proper way in any one or more embodiments or examples. In addition, a person skilled in the art may combine different embodiments or examples described in the present specification, as well as features of the different embodiments or examples, without mutual contradiction.

Although the embodiments of the present disclosure have been shown and described above, it can be understood that the above embodiments are exemplary and cannot be understood as limitations to the present disclosure. Ordinary technical person in the art may make changes, modifications, substitutions, and variations to the above embodiments in the scope of the present disclosure.

## Claims

1. A display panel, wherein the display panel has a display region comprising a first display region and a second display region, and a density of pixel circuits in the first display region is less than a density of pixel circuits in the second display region; the display panel comprises:
a base substrate;
a plurality of first pixel circuits disposed on the base substrate and located in the second display region;
a plurality of first traces disposed on a side of the first pixel circuits away from the base substrate;
a pixel defining layer disposed on a side of the first traces away from the base substrate and defining a plurality of openings;
a plurality of first light emitting devices disposed on the side of the first traces away from the base substrate and located in the first display region, wherein the first light emitting devices have effective light emitting regions respectively located in the openings, the first light emitting devices have first anodes each comprising an effective light emitting anode region and a non-light emitting anode region disposed surrounding the effective light emitting anode region, and the pixel defining layer covers the non-light emitting anode region;
wherein the first traces are respectively electrically connected with the first pixel circuits through first vias and respectively electrically connected with the first anodes through second vias, and orthographic projections of the second vias on the base substrate are respectively located in orthographic projections of the first anodes on the base substrate.

2. The display panel according to claim 1, wherein the openings are shaped as circles, parts of circles, ovals or parts of ovals, and/or the first anodes are shaped as circles or ovals.

3. The display panel according to claim 2, wherein the first light emitting devices comprise blue light emitting devices, red light emitting devices and green light emitting devices, first anodes in the blue light emitting devices are shaped as circles or sub-circular ovals, and first anodes in the red light emitting devices and the green light emitting devices are shaped as ovals.

4. The display panel according to claim 1, further comprising:
a first insulating layer disposed on the side of the first pixel circuits away from the base substrate, wherein the plurality of first traces are disposed on a surface of the first insulating layer away from the base substrate and respectively electrically connected with the first pixel circuits through the first vias penetrating the first insulating layer;
a second insulating layer disposed on the surface of the first insulating layer away from the base substrate and covering the first traces, wherein the pixel defining layer is disposed on a side of the second insulating layer away from the base substrate, and the first anodes are respectively electrically connected with the first traces through the second vias penetrating the second insulating layer.

5. The display panel according to any one of claims 1 to 4, wherein portions of the orthographic projections of the second vias on the base substrate are respectively covered by orthographic projections of effective light emitting anode regions on the base substrate, and other portions of the orthographic projections of the second vias on the base substrate are respectively covered by orthographic projections of non-light emitting anode regions on the base substrate.

6. The display panel according to any one of claims 1 to 4, wherein the orthographic projections of the second vias on the base substrate are respectively covered by orthographic projections of non-light emitting anode regions on the base substrate.

7. The display panel according to any one of claims 1 to 4, wherein the orthographic projections of the second vias on the base substrate are respectively covered by orthographic projections of effective light emitting anode regions on the base substrate.

8. The display panel according to any one of claims 1 to 4, wherein a material forming the first traces comprises at least one of ITO and AZO.

9. The display panel according to claim 1, further comprising:
a plurality of second pixel circuits and a plurality of second light emitting devices that are both located in the second display region, wherein the second pixel circuits are respectively connected with second anodes in the second light emitting devices by at least one of following means:
the second pixel circuits are directly electrically connected with the second anodes in the second light emitting devices through third vias, to drive the second light emitting devices to emit light;
the display panel further comprises a conductive layer disposed in a same layer as the first traces, the second anodes are electrically connected with the conductive layer through fourth vias penetrating the second insulating layer, and the conductive layer is electrically connected with the second pixel circuits through fifth vias penetrating the first insulating layer, to drive the second light emitting devices to emit light.

10. A display apparatus, comprising:
the display panel according to any one of claims 1 to 9;
an under-screen functional layer, wherein an orthographic projection of the under-screen functional layer on the display panel overlaps the first display region of the display panel.
